(19)

Europäisches
Patentamt
European
Patent Office
Office européen
des brevets

(11) **EP 3 405 816 B1**

(12) **EUROPEAN PATENT SPECIFICATION**

(45) Date of publication and mention
of the grant of the patent:
**15.01.2020 Bulletin 2020/03**

(21) Application number: **17702256.3**

(22) Date of filing: **19.01.2017**

(51) Int Cl.:
*G01V 1/50* *(2006.01)*          *G01V 99/00* *(2009.01)*

(86) International application number:
**PCT/US2017/014019**

(87) International publication number:
**WO 2017/127476 (27.07.2017 Gazette 2017/30)**

(54) **SYSTEM AND METHOD FOR MODELING THE EFFECTS OF FLUID CHANGES IN LOW POROSITY HYDROCARBON RESERVOIRS**

SYSTEM UND VERFAHREN ZUR MODELLIERUNG DER AUSWIRKUNGEN VON FLUIDÄNDERUNGEN IN KOHLENWASSERSTOFFRESERVOIRS MIT GERINGER POROSITÄT

SYSTÈME ET PROCÉDÉ DE MODÉLISATION DES EFFETS DE CHANGEMENTS DE FLUIDE DANS DES RÉSERVOIRS D'HYDROCARBURES À FAIBLE POROSITÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **22.01.2016 US 201615004053**

(43) Date of publication of application:
**28.11.2018 Bulletin 2018/48**

(73) Proprietor: **Chevron U.S.A. Inc.**
**San Ramon, CA 94583 (US)**

(72) Inventor: **SKELT, Christopher Hugh**
**San Ramon, CA 94583 (US)**

(74) Representative: **Haseltine Lake Kempner LLP**
**Redcliff Quay**
**120 Redcliff Street**
**Bristol BS1 6HU (GB)**

(56) References cited:
**US-A- 4 964 096     US-B2- 8 219 319**

- **R. SIMM: "Practical Gassmann fluid substitution in sand/shale sequences", FIRST BREAK, vol. 25, no. 1114, December 2007 (2007-12) , XP055358857, DOI: 10.3997/1365-2397.2007030**
- **SAM ZANDONG SUN ET AL: "The theory and application of DEM-Gassmann rock physics model for complex carbonate reservoirs", THE LEADING EDGE, vol. 31, no. 2, February 2012 (2012-02), pages 152-158, XP055358862, US ISSN: 1070-485X, DOI: 10.1190/1.3686912**
- **DVORKIN J ET AL: "FLUID SUBSTITUTION IN SHALEY SEDIMENT USING EFFECTIVE POROSITY", GEOPHYSICS, SOCIETY OF EXPLORATION GEOPHYSICISTS, US, vol. 72, no. 3, May 2007 (2007-05), pages O01-O08, XP001540917, ISSN: 0016-8033, DOI: 10.1190/1.2565256**
- **KEYS,ROBERT G. ET AL.: "An approximation for the Xu-White velocity model", GEOPHYSICS, vol. 67, no. 5, October 2002 (2002-10), page 1406, XP002768687, DOI: 10.1190/1.1512786**

**Description**

**TECHNICAL FIELD**

The disclosed embodiments relate generally to techniques for modeling the effects of fluid changes on subsurface elastic properties and, in particular, to a method of estimating fluid effects in low porosity subsurface reservoirs based on shear modulus data.

**BACKGROUND OF THE INVENTION**

Evaluation of the economic potential and management of a subsurface reservoir requires understanding the fluid content of the rock formations in the reservoir. This is particularly challenging for low porosity reservoirs in which the fluid effects modeled for various saturations are similar in magnitude to errors in the input data and limitations of the equations used for the modeling. In particular, using the standard Gassmann equation results in increased uncertainty in the computed dry frame bulk modulus in low porosity reservoirs. This in turn will result in errors in the estimated fluid effects and poor models of the seismic response to fluid changes.

There is a need for improved methods and systems for modeling the effects of different fluids on subsurface elastic properties in order to evaluate fluid content of low porosity subsurface reservoirs in order to estimate the economic potential of exploration prospects and to plan well design and placement.

**SUMMARY OF THE INVENTION**

Described herein are implementations of various approaches for a computer-implemented method for modeling fluid effects in a subsurface reservoir. The modeled fluid effects may be used to evaluate expected responses on measured seismic data representative of the subsurface reservoir.

In one embodiment, a computer-implemented method for modeling fluid effects in a subsurface reservoir include receiving, at a computer processor, a plurality of well logs from a subsurface reservoir and conducting a petrophysical evaluation to determine in-situ porosity, fluid saturation, and lithology; deriving dry frame properties including bulk and shear modulus and Poisson's ratio from the well logs and evaluation results via a Gassmann equation based method; aggregating the dry frame properties and plotting the dry frame properties versus porosity and by lithology and dividing the plots into bins covering limited porosity and lithology ranges; calculating a median porosity-dry frame Poisson's ratio pair for each bin and deriving a mathematical model to interpolate between medians for any arbitrary porosity-lithology pair to determine interpolated dry frame Poisson's ratios; using the combination of a shear modulus from density and shear sonic logs from the plurality of well logs and the interpolated dry frame Poisson's ratio to estimate a modeled dry frame bulk modulus; using the modeled dry frame bulk modulus to estimate the difference via the Gassmann equation-based method between dry frame compressional and shear velocity and density compressional and shear velocity and density at a plurality of modeled fluid saturations; and adjusting recorded compressional and shear velocity and density logs from the plurality of well logs according to the difference between properties at in-situ fluid saturation and the plurality of modeled fluid saturations, and transforming velocity and density to other modeled elastic properties. The method may further include estimating the influence of fluid fill on measured seismic data based on the modeled elastic properties. The method is designed to overcome the limitations of the standard Gassmann-based approach for low porosity and mixed lithology subsurface reservoirs but may also be confidently applied at high porosity

In another embodiment, a computer system including a data source or storage device, at least one computer processor and a user interface used to implement the method for modeling fluid effects in a subsurface reservoir is disclosed.

In yet another embodiment, an article of manufacture including a computer readable medium having computer readable code on it is disclosed, the computer readable code being configured to implement a method for modeling fluid effects in a subsurface reservoir.

The above summary section is provided to introduce a selection of concepts in a simplified form that are further described below in the detailed description section. The summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

**BRIEF DESCRIPTION OF THE DRAWINGS**

These and other features of the present invention will become better understood with regard to the following description, claims and accompanying drawings where:

Figure 1A is graph of bulk modulus versus shear modulus computed from representative density and compressional and shear slowness values with random noise added to create a data cloud illustrating the relative sensitivity of the properties to noise;

Figure 1B is graph of Poisson's ratio versus shear modulus computed from representative density and compressional and shear slowness values with random noise added to create a data cloud illustrating the relative sensitivity of the properties to noise;

Figure 2 shows well log derived petrophysical analysis and calculated elastic properties using prior art methods as compared with calculated properties using an embodiment of the present invention in a low porosity reservoir;

Figure 3 shows well log derived petrophysical analysis and calculated elastic properties using prior art methods as compared with calculated properties using an embodiment of the present invention in a high porosity reservoir;

Figure 4 shows graphs of the dry frame bulk modulus versus porosity for different shale volume ranges with data driven trend curves superimposed;

Figure 5 shows graphs of the dry shear modulus versus porosity for different shale volume ranges with data driven trend curves superimposed;

Figure 6 shows graphs of the dry frame Poisson's ratio versus porosity for different shale volume ranges with data driven trend curves superimposed;

Figure 7 summarizes the trends shown on the individual panels of Figures 4 - 6;

Figure 8 shows well logs and calculated properties including adjusted and estimated compressional slowness using embodiments of the present invention;

Figure 9 shows well logs and calculated properties including the difference between modeled gas and brine filled compressional slowness using embodiments of the present invention;

Figure 10 shows fluid effects on elastic properties as calculated using the standard Gassmann equation in accordance with an embodiment of the present invention;

Figure 11 shows well logs and calculated properties using an embodiment of the present invention including calculated apparent fluid mixture properties, the corresponding fluid saturations, and a derived water saturation profile;

Figure 12 illustrates a flow chart of two embodiments of the present invention; and

Figure 13 schematically illustrates a system for performing a method in accordance with an embodiment of the invention.

## DETAILED DESCRIPTION OF THE INVENTION

The present invention is described and implemented in the general context of a system and computer methods to be executed by a computer. Such computer-executable instructions may include programs, routines, objects, components, data structures, and computer software technologies that can be used to perform particular tasks and process abstract data types. Software implementations of the present invention may be coded in different languages for application in a variety of computing platforms and environments. It will be appreciated that the scope and underlying principles of the present invention are not limited to any particular computer software technology.

Moreover, those skilled in the art will appreciate that the present invention may be practiced using any one or combination of hardware and software configurations, including but not limited to a system having single and/or multiple processor computers, hand-held devices, tablet devices, programmable consumer electronics, mini-computers, mainframe computers, and the like. The invention may also be practiced in distributed computing environments where tasks are performed by servers or other processing devices that are linked through one or more data communications network. In a distributed computing environment, program modules may be located in both local and remote computer storage media including memory storage devices.

Also, an article of manufacture for use with a computer processor, such as a CD, pre-recorded disk or other equivalent devices, may include a tangible computer program storage medium and program means recorded thereon for directing the computer processor to facilitate the implementation and practice of the present invention. Such devices and articles of manufacture also fall within the scope of the present invention.

Referring now to the drawings, embodiments of the present invention will be described. The invention can be implemented in numerous ways, including, for example, as a system (including a computer processing system), a method (including a computer implemented method), an apparatus, a computer readable medium, a computer program product, a graphical user interface, a web portal, or a data structure tangibly fixed in a computer readable memory. Several embodiments of the present invention are discussed below. The appended drawings illustrate only typical embodiments of the present invention and therefore are not to be considered limiting of its scope and breadth.

The present invention addresses the challenges faced by petrophysicists when conducting fluid substitution in low porosity sandstone reservoirs. Standard Gassmann equation based methods work well at high porosity where the fluid effects are large compared with errors in the input data and limitations of the equations embedded in the workflows. These workflows combine compressional and shear sonic logs to derive in-situ bulk modulus and invoke the Gassmann equation to estimate bulk modulus at dry frame conditions. Estimation of elastic properties at other fluid saturations requires a further application of the Gassmann equation. The success of this second step depends on the validity of the dry frame bulk modulus computation. At low porosity, not only are the fluid effects similar in magnitude to the errors and uncertainties in the input data, but additional factors related to configuring the Gassmann model conspire to increase uncertainty in computed dry frame bulk modulus causing errors and instability in estimated fluid effects and degraded models of seismic response to fluid changes.

Historically, shear sonic data was in short supply or of poor quality, so workflows included estimation of bulk modulus from recorded compressional log and a synthetic shear log. Shear sonic log estimation relies on the observation that under similar saturation conditions (for example dry frame or brine filled) the ratio of compressional to shear velocity (Vp/Vs ratio) or Poisson's ratio (derived from Vp/Vs ratio) is generally a stable function of lithology and porosity.

Present day sonic tools such as Schlumberger's Sonic Scanner™, introduced some ten years ago, deliver high quality shear data and therefore shear modulus availability (the product of formation density and shear velocity squared) following shear sonic acquisition is now routine. Because shear modulus is unaffected by fluid content changes, it does not require transformation to dry frame conditions-a significant source of error in deriving dry frame bulk modulus from recorded logs.

The present invention combines the high quality shear modulus data from modern sonic logs with the inherent stability of Vp/Vs ratio to derive more stable and credible dry frame bulk modulus than obtained using the Gassmann equation to transform observed bulk modulus to dry frame. The Gassmann equation is used for the second step of the modeling process, transforming from dry frame to modeled saturation, and the stable input moduli ensure stable results. This improves models of the effects of fluid changes on elastic properties of hydrocarbon reservoirs. The result is better understanding of the contribution of fluid effects to subtle phenomena observed on seismic data, more confidence diagnosing in-situ fluids, and more accurate prognoses of the outcome of future wells.

The present invention specifically addresses shortcomings of estimating fluid effects on the compressional sonic logs when using the Gassmann equation to transform from in-situ to dry frame conditions in low porosity reservoirs. Comprehensive elastic modeling also requires adjusting shear velocity and density for fluid effects. The models currently used for this are not prejudiced by low porosity, and this invention does not depart from present day practices in this respect.

Several embodiments are presented, all of which share estimation of the effect of fluid effects-the difference between elastic properties at dry frame and modeled saturation conditions-from dry frame bulk modulus derived from shear modulus and an estimate of dry frame Poisson's ratio instead of from Gassmann's equation. Gassmann's equation is used to transform from dry frame to modeled saturation, and this step benefits from the more stable input moduli derived from this invention.

In the first embodiment, the petrophysicist is confident in the in-situ saturation interpretation. The fluid effects are determined by applying the Gassmann equation to dry frame bulk modulus calculated from recorded shear modulus and estimated Poisson's ratio, and the recorded compressional log adjusted from in-situ to modeled saturation according to the calculated fluid effects.

In the second embodiment, the petrophysicist cannot determine if the formation is brine saturated or has low gas saturation. Because the saturation is indeterminate, so is any fluid effect on the compressional sonic log. Dry frame compressional velocity is estimated from dry frame density and bulk and shear moduli. Compressional velocity at modeled saturation is calculated by running the Gassmann equation on dry frame elastic properties without relying on a saturation interpretation.

In an extension of this embodiment, a comparison of modeled and recorded compressional sonic logs is used to diagnose in-situ fluids.

The second embodiment is also appropriate if the petrophysicist is more confident in the shear than the compressional log data quality as it permits creating a synthetic compressional sonic log for comparison with the recorded data or to overwrite it.

The present invention overcomes the instability inherent in present day Gassmann equation based computation of dry frame bulk modulus and delivers more stable and credible results. The occurrence of instability is well known among those well versed in the art, and has led to methods to overcome it. One approach is to use a rock physics model based on grain contact theory (see, for example, The Rock Physics Handbook Section 5.4, p245 et seq. Mavko G, Mukerji T and Dvorkin J, 2010, The Rock Physics Handbook, Second Edition, Cambridge University Press) or abstract geometric properties (see, for example, Xu, S and White RE, 1995, A new velocity model for clay-sand mixtures, Geophysical Prospecting, 43, 91-118), or a purely data-driven methods to estimate dry frame shear and bulk moduli from (for example) porosity, lithology etc.

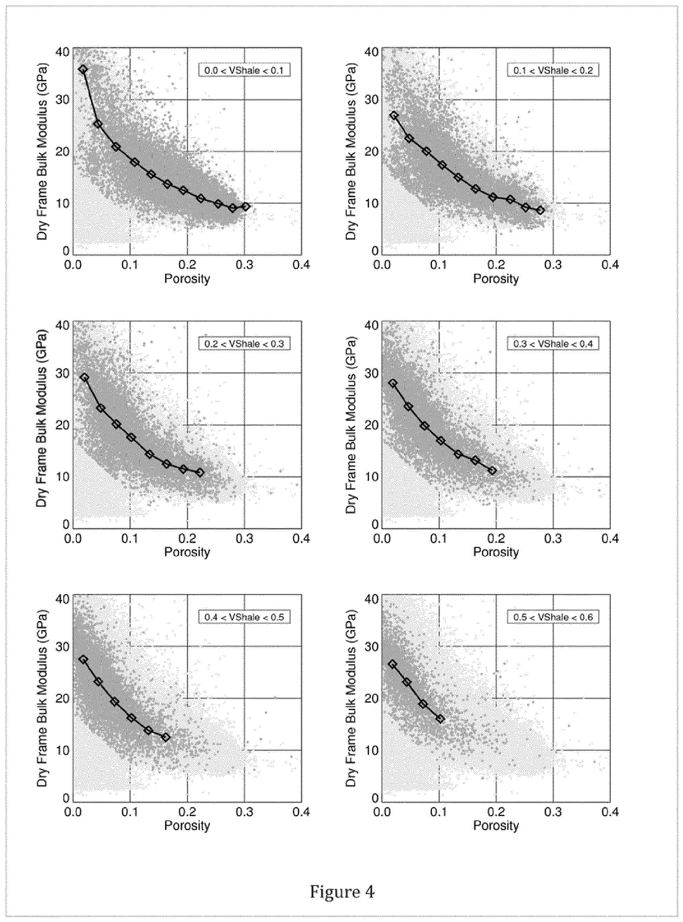

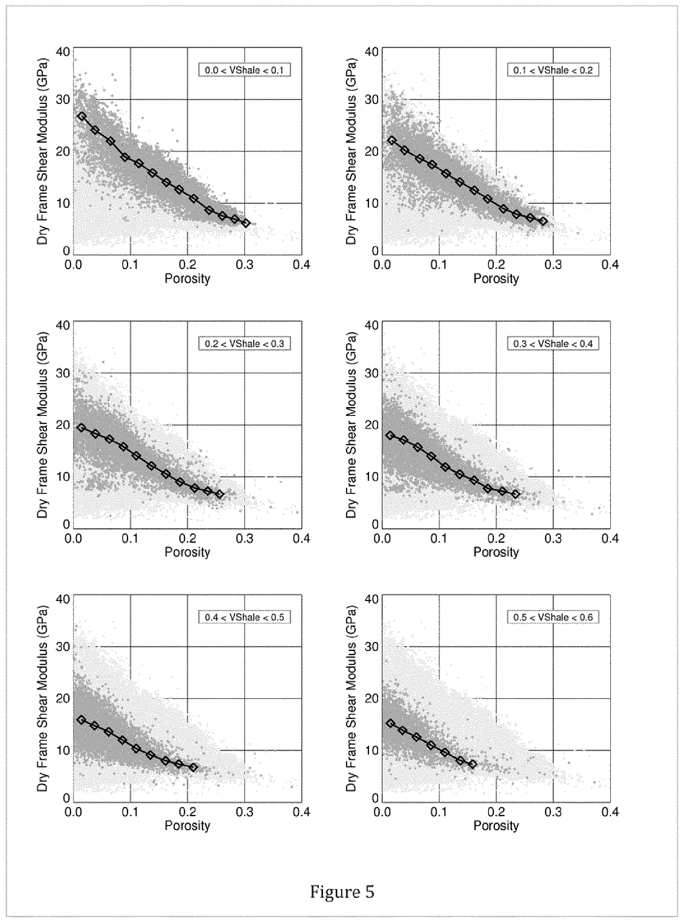

For example, the results shown on Figures 4 and 5 could be used deliver data-driven stable dry frame properties from porosity and lithology. While these methods may work in some circumstances they do not allow for real heterogeneity in the earth. Two rocks with the same porosity and lithology may have quite different stiffness if they differ in cementation or texture-properties that cannot realistically be estimated from foot by foot wireline log measurements-and so these methods tend to present an overly homogeneous picture of the earth. By using the recorded shear log as an active input to the model we honor real heterogeneity that is otherwise understated or missed.

Smith's method (Smith T, "Practical Seismic Petrophysics: The effective use of log data for seismic analysis," 2011, The Leading Edge, October 2011, pp 1128 - 1141) assumes that dry frame Poisson's ratio is close to that of the solid material. This is a result familiar to those who have worked with grain contact theory, and is a consequence of the stress path assumptions inherent in these models. It requires the user to estimate the solid's shear and bulk and shear moduli in order to estimate dry frame bulk modulus $K_{df}$ from shear modulus G via the formula $K_{df} = G \times (K_s/G_s)$ where the subscript "s" denotes solid. In principle this overcomes the shortcomings of the model and data driven approaches listed above by permitting variation in dry frame stiffness at a given porosity-lithology combination.

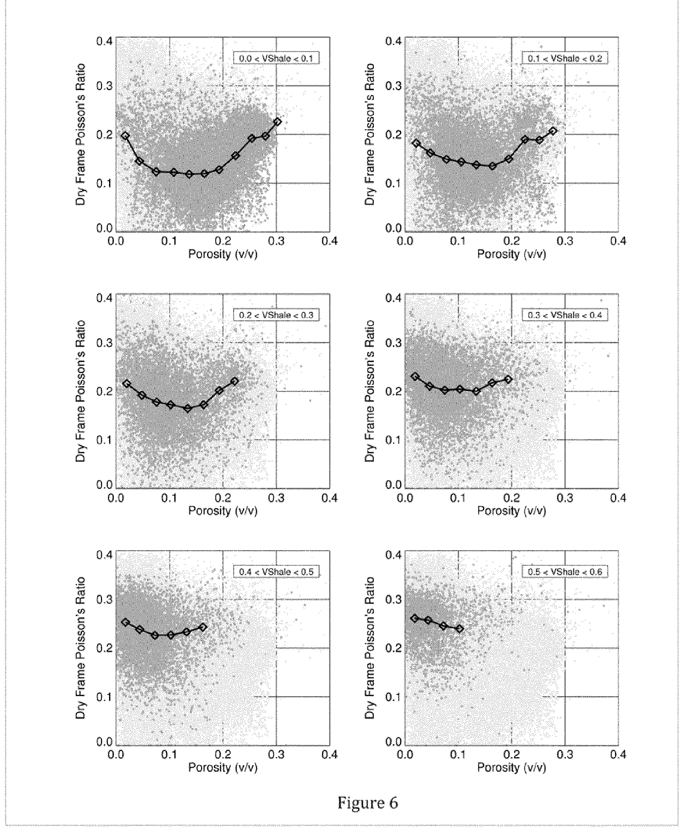

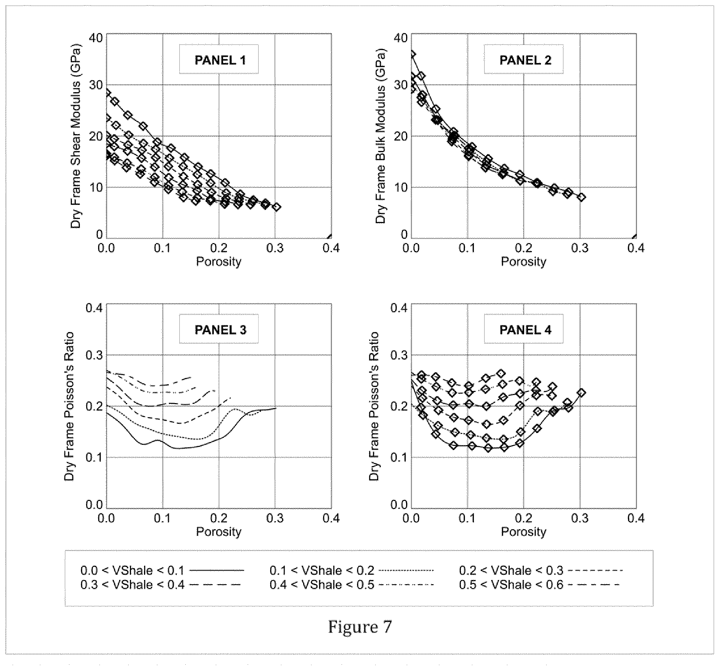

Smith proposes iterating towards final estimates of solid modulus by trial and error. The present invention does not require an explicit shear modulus of the solid (although an estimate is a by-product of the splined fits on Figure 5). In any case the data on Figure 6 indicate a strong porosity dependence observed elsewhere and cited by Saul et al. (Saul M, Lumley D and Shragge J, 2013, "Modeling the pressure sensitivity of uncemented sediments using a modified grain contact theory: Incorporating grain relaxation and porosity effects. Geophysics, 78, No 5, 327 - 338) as well as significant lithology-related variation in shear modulus and Poisson's ratio in reservoir quality rock. The porosity dependence highlights shortcomings of the stress path assumptions cited above that are now becoming appreciated by the geophysical community. The unique attribute of this aspect of the present invention is that it applies robust statistics on a regional dataset to estimate dry frame Poisson's ratio without invoking guidance from favored models or conventional wisdom. Figure 7 endorses this approach by emphasizing that defining trends from medians identifies well-behaved relations in apparently noisy data.

Dynamic dry frame shear and bulk moduli derived from wireline log data have different credibility. Sound estimates of dry frame elastic properties are fundamental to modeling elastic properties at other fluid saturation conditions. Standard practice is to use two equations to transform from dry frame to modeled fluid saturations-the Gassmann equation for bulk modulus and the assertion that shear modulus is unaffected by fluid content. A credible shear modulus only requires good quality density and shear sonic logs and confidence that radial saturation variation does not introduce a material error. In contrast, the bulk modulus requires a credible shear modulus as well as the data required to populate the Gassmann equation namely:

1. A good quality compressional sonic log to use with the density and shear log to compute formation bulk modulus. Compressional slowness is more sensitive than shear to fluid saturation changes, so radial saturation changes are potentially more troublesome.
2. An accurate porosity estimate.
3. Knowledge of fluid modulus, for example confidence in the absence of low saturation gas or a dependable estimate of its saturation.
4. A good estimate of solid modulus. In mixed lithology such as shaley sands, this requires an accurate estimate of the lithology, the properties of the components, and a mixing law to define the properties of the mixture.
5. And the Gassmann equation requirements need to be fulfilled viz. equilibration of fluid pressure under excitation by the acoustic wave.

Dry frame bulk modulus is clearly a more difficult quantity to estimate using current standard practices than shear modulus, which is why the shear modulus and a regional Poisson's ratio model are used in this embodiment of the present invention.

Compressional and shear sonic logs are derived from waveforms recorded by an array of receivers. Limitations in data acquisition technology and waveform processing algorithms cause errors and uncertainties in the resulting compressional and shear slowness. And near wellbore mechanical alteration may alter the formation properties from far-field conditions. The following table lists typical properties for brine filled sands at low and high porosity. Bulk and shear modulus and Poisson's ratio are calculated from density and compressional and shear slowness using well-known relations from linear elastic theory.

In addition, the sensitivity to errors in compressional and shear sonic logs must be considered. Compressional and shear sonic logs are derived from waveforms recorded by an array of receivers. Limitations in data acquisition technology and waveform processing algorithms cause errors and uncertainties in the resulting compressional and shear slowness. And near wellbore mechanical alteration may alter the formation properties from far-field conditions. The following table lists typical properties for brine filled sands at low and high porosity. Bulk and shear modulus and Poisson's ratio are calculated from density and compressional and shear slowness using well-known relations from linear elastic theory.

|  | Porosity v/v | Density g/cm3 | DTc $\mu$s/ft | DTs $\mu$s/ft | Bulk Mod GPa | Shear Mod GPa | Poisson's ratio |
|---|---|---|---|---|---|---|---|
| **Fast formation** | 0.12 | 2.47 | 70 | 110 | 21.54 | 18.96 | 0.160 |
| **Slow formation** | 0.30 | 2.16 | 100 | 185 | 12.25 | 5.86 | 0.294 |

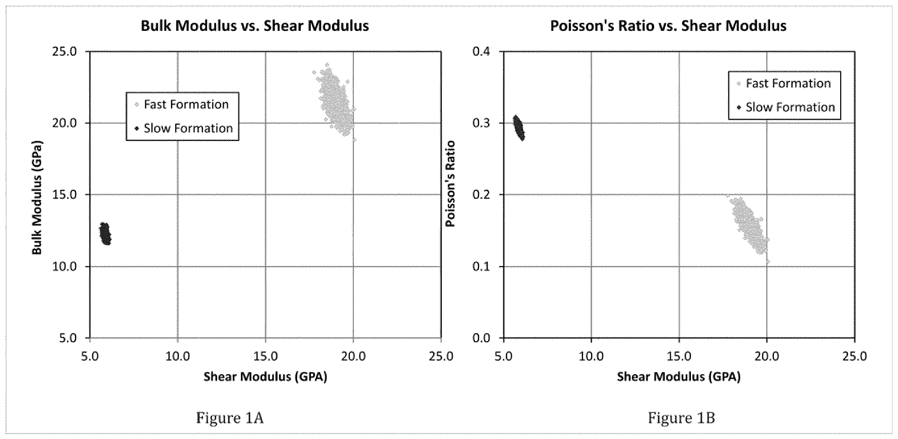

The plots in Figures 1A and 1B show the effects of adding normally distributed noise with standard deviation 0.5 and 1.0 microseconds per foot (per 0.3048m) to the compressional and shear slowness values above. This noise has a proportionally larger effect on bulk modulus than on shear modulus-not surprising because the former includes errors from compressional and shear slowness. The effect on computed Poisson's ratio is very much larger in fast formations.

These results are an inevitable consequence of the mathematical relations between slowness and elastic properties. This observation implies that we can estimate shear modulus more robustly than bulk modulus, and small amounts of noise may severely limit our ability to use the two to estimate Poisson's ratio at a low porosity data point.

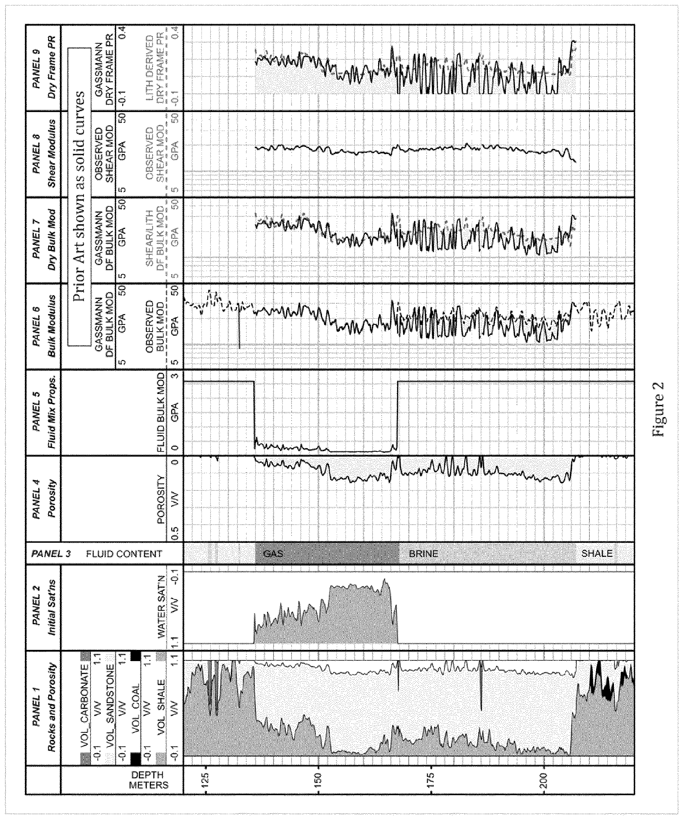

Another issue that must be considered is that modeled fluid effect stability depends on the original fluids. A good estimate of bulk modulus at modeled saturation relies on frame modulus. The dry frame modulus estimate's validity varies with fluid content. Figure 2 shows how transformation via the Gassmann equation from observed to dry frame conditions in a brine filled zone result in an unstable bulk modulus in porosity similar to the "fast formation" of Figures 1A and 1B. The observed and Gassmann-derived dry frame bulk modulus are presented on panel 6-indistinguishable in the gas zone where the fluid modulus (panel 5) is low, and larger and unstable in the brine zone where the fluid modulus is that of water.

The gray dashed curves in panels 7 to 9 are as proposed by the invention. They will be described in more detail in the next section, and are plotted to emphasize their stability and immunity to fluid changes compared with the solid curves corresponding to prior art.

Shear modulus is unaffected by fluids. The two identical observed shear modulus curves are always more stable than the bulk modulus due to the effects explained previously and shown on Figure 1 and nor does their character change across the gas-water contact.

The noise on bulk modulus propagates to noise on Poisson's ratio and significant instability in the brine zone. This implies that relations between dry frame bulk modulus and Poisson's ratio can be more clearly identified in results derived from gas-filled intervals, and prompts giving them precedence over brine filled intervals when building regional models.

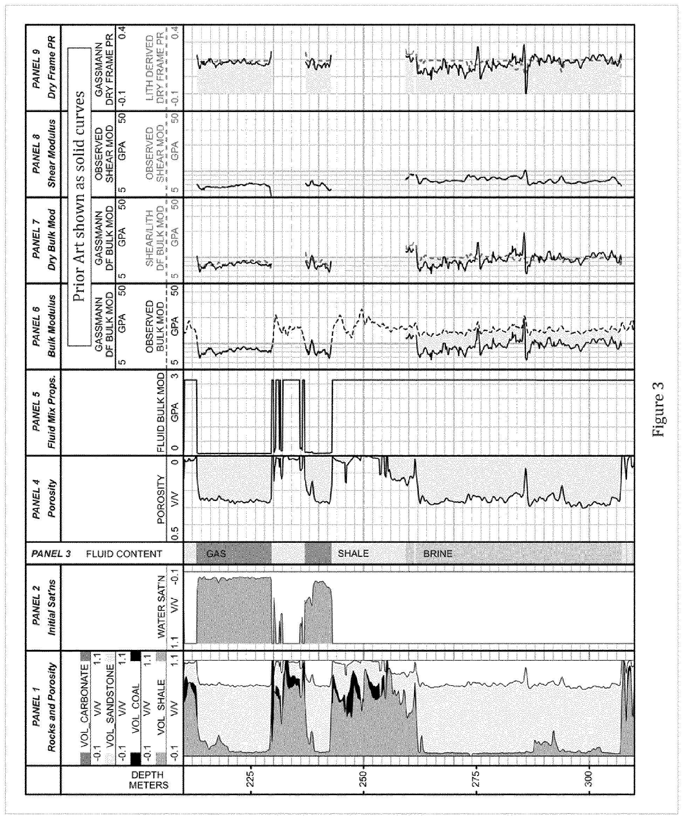

The data and observations presented on Figure 2 are representative of low (about 0.1 to 0.15 v/v units) porosity formations. For comparison, Figure 3 shows the same computations run on a higher (about 0.25 to 0.3 v/v units) porosity formation with properties similar to the "slow formation" of Figures 1A and 1B. The contrast in stability between calculated bulk and shear moduli and the influence of fluids observed on Figure 2 is present, but although the difference between observed and dry frame bulk modulus is proportionally larger in the brine filled interval (panel 6) the instability introduced from the combined effect of noise on the original data and the vagaries of the Gassmann equation is less, particularly for dry frame Poisson's ratio.

These two effects-noise on the input data and the consequences of applying the Gassmann equation-introduce instability to computed results irrespective of porosity. However, while the instability on dry frame bulk modulus is small compared with the fluid effects in a high porosity brine filled formation giving no reason to question the workflow and results, the errors and uncertainties in the data and models dominate the response at low porosity. A comparison of Figures 2 and 3 emphasizes the need for an approach that overcomes the instability observed at low porosity. The approach presented here overcomes the low porosity problems listed here, and works equally well at high porosity.

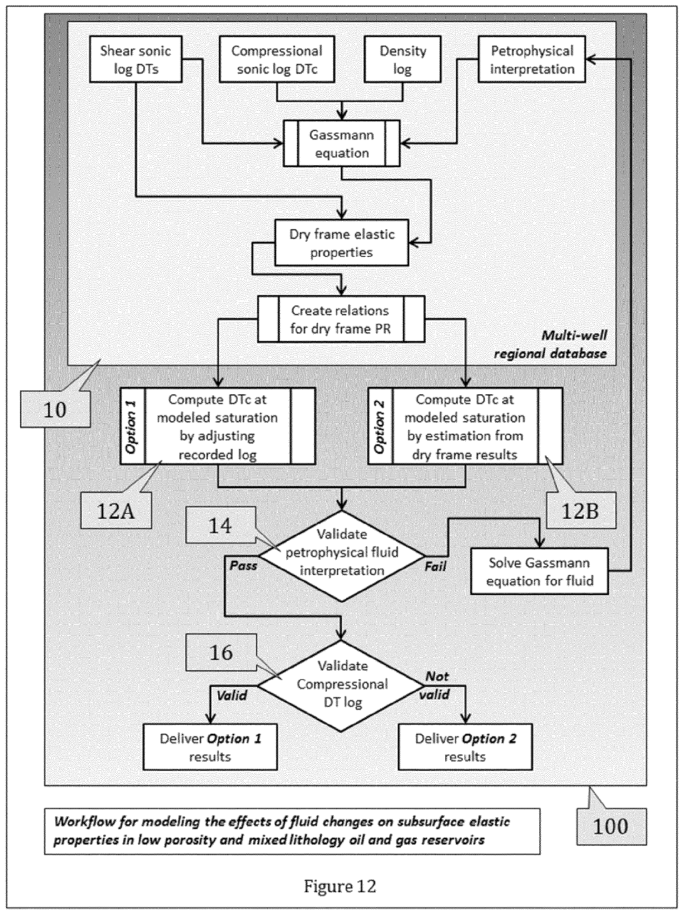

The present invention relates to deriving elastic properties at diverse fluid saturations from the density and sonic logs by fluid substitution. One embodiment of the present invention is shown as method 100 in Figure 12.

**Deriving dry frame bulk modulus from shear modulus and a Poisson's ratio model**

The fundamental premise of this invention is that recorded shear modulus and a local data-derived relation defining dry frame Poisson's ratio from porosity and lithology deliver a more accurate and stable dry frame bulk modulus in low porosity formations than can be achieved by invoking the Gassmann equation.

Geophysicists use models of the elastic properties of the subsurface to interpret in-situ lithology and fluids from seismic data. Subsurface elastic moduli and impedance are derived from bulk density and compressional and shear sonic logs recorded on wireline or from sensors embedded in the drill string. Present day practices include modeling the effects of fluid changes on compressional velocity using the Gassmann equation that links porosity and the bulk moduli of the whole formation, the solid, fluid and dry frame.

Elastic properties at diverse fluid saturations are derived from the density and sonic logs by fluid substitution. Fluid effects on the density log honor simple linear superposition, and shear sonic log (*DTs*) adjustments are made on the basis that shear modulus G, the product of density and the square of shear velocity, is unaffected by fluid content. Compressional slowness *DTc,* scaled in microseconds per foot, or its equivalent velocity *Vp* in kilometers per second are derived in the bulk modulus domain at various modeled saturations by applying the Gassmann equation followed by the linear elastic relation...

$$\frac{304.8}{DTc} = V_p = \sqrt{K_b + \frac{4}{3}G} \qquad \dots (1)$$

This requires first computing dry frame bulk modulus $K_{df}$ using the Gassmann equation as in equation 2 below, followed by a second bulk modulus computation from dry frame to modeled saturations as in equation 3. The subscripts "b" and "s" denote bulk and solid.

$$K_{df} = \frac{K_b \left( \dfrac{\phi}{K_{initial\ fluid}} + \dfrac{1-\phi}{K_s} \right) - 1}{\dfrac{\phi}{K_{initial\ fluid}} + \dfrac{1-\phi}{K_s} - \dfrac{2}{K_s} + \dfrac{K_b}{K_s^2}} \qquad \dots (2)$$

$$K_{b\ modeled} = K_{df} + \frac{\left( 1 - \dfrac{K_{df}}{K_s} \right)^2}{\dfrac{\phi}{K_{modeled\ fluid}} + \dfrac{1-\phi}{K_s} - \dfrac{K_{df}}{K_s^2}} \qquad \dots (3)$$

This dependence on the Gassmann equation for modeling is widespread and familiar to those well versed in the art. However, results are only as good as the ability of the Gassmann equation to derive valid dry frame modulus from the other three moduli (bulk, solid and fluid) and porosity. When considering high porosity reservoirs, for example with porosity greater than 0.2, these methods usually deliver results that can be used with confidence, and have supported the discovery and successful appraisal of many hydrocarbon reservoirs over the past few decades. However, certain mathematical and physical factors cause the computation of dry frame bulk modulus to break down as porosity reduces, prompting the question... "*Is there a better way of estimating dry frame bulk modulus that is more appropriate to low porosity reservoirs?*"

We introduce a new method for estimating dry frame modulus and compare it with results from standard practices to demonstrate that it works as well at high porosity and better at low porosity. Although the supporting data are from gas reservoirs, the invention applies equally to oil.

Linear elastic theory relates shear and bulk modulus and Poisson's ratio (K, G and PR respectively) via the equation...

$$PR = \frac{3K - 2G}{6K + 2G} \qquad \ldots (4)$$

Unlike bulk modulus that varies with fluid content, shear modulus is unaffected by fluids. This means that dry frame shear modulus is identical to the shear modulus derived from the product of the density and the square of the shear velocity logs recorded in the well at any in-situ saturation.

Study of large regional data sets indicates that Poisson's ratio is a stable function of formation velocity (compressional or shear) and lithology at constant saturation conditions. The ability of the Greenberg-Castagna formula (Greenberg, M.L. and Castagna, J.P, 1992, Shear wave velocity estimation in porous rocks: Theoretical formulation, preliminary verification and applications, Geophysical Prospecting, 40, 195 - 209) to estimate shear from compressional velocity in mixed lithology brine filled formations is evidence of this.

Equation 4 may be rearranged to estimate dry frame bulk modulus from shear modulus derived from the logs at in-situ conditions and a dry frame Poisson's ratio estimate viz...

$$K_{df} = \frac{2G \times (1 + 2PR_{df})}{3 \times (1 - 2PR_{df})} \qquad \ldots (5)$$

Although Gassmann equation derived dry frame bulk modulus and the corresponding Poisson's ratio are unstable and noisy, the physics is sound, and we believe there is valid information in the data that points to the underlying relationships within the earth. Figure 4 shows dry frame bulk modulus from a dataset of wells penetrating fluvial sands spanning a vertical interval of several thousand meters, with a wide range in porosity. The light gray points are all the data, while the darker gray data on each panel are from the posted range in shale fraction (VShale). The data were subdivided into consecutive porosity bins with width of 0.03 v/v units, and the diamonds are the median porosity and dry frame bulk modulus for each bin. The diamonds are joined by straight lines to aid visualization. At the lower left of each panel there is evidence of truncation of the computation. This is needed to prevent physically absurd results, and does not affect the median values of the data. The scatter in the data set even after truncation is noteworthy.

Figure 5 shows an analogous plot for shear modulus. The appearance of less scatter is not an illusion. The combination of noisy dry frame bulk modulus and less noisy shear modulus yields very unstable dry frame Poisson's ratio data points on Figure 6 computed from equation 3. Nonetheless the porosity bin medians are stable. Joining the medians on Figures 4 to 6 with splined fits gives the results on panels 1, 2 and 4 on Figure 7. Panel 3 shows relations for dry frame Poisson's ratio derived by applying equation 4 to the splined fits joining the diamonds on panels 1 and 2. The data show that systematic trends are present in the data-little sensitivity of bulk modulus to lithology and a well-defined lithology dependence of shear modulus combine to give the lithology and porosity dependence of Poisson's ratio on panels 3 and 4. Whether the lithology and porosity dependence of Poisson's ratio is computed from the dry frame moduli or directly from the Poisson's ratio data has little influence on the final results so both alternatives are options.

The dry frame Poisson's ratio for a given porosity-VShale pair is derived by interpolation between adjacent splined fits. For example, consider the splines for shale fraction range 0.1 to 0.2 and 0.2 to 0.3 as characteristic of shale fractions of 0.15 and 0.25. The result for a data point with shale fraction of (say) 0.21 would be 0.6 times the value of the 0.2 to 0.3 spline plus 0.4 time the value of the 0.1 to 0.2 spline at the porosity of the data point.

Finally, dry frame bulk modulus is calculated from measured shear modulus and estimated Poisson's ratio using equation 5.

To summarize, the workflow supporting this calculation is shown in the block 10 figure 12 and written as follows:

1. Using all the available data, compute porosity, shale fraction (or some other relevant lithology index) and water saturation using standard petrophysical practices.

2. Derive shear modulus from the density and shear sonic logs. Divide the data into bins containing a limited porosity and shale fraction range and compute medians of porosity and shear modulus for each bin. Define a continuous function from zero porosity to the maximum encountered for each shale fraction range with a splined or similar fit.

3. Derive bulk modulus from the density and shear and compressional sonic logs and transform to dry frame conditions using the Gassmann equation. Divide the data into bins containing a limited porosity and shale fraction range and compute medians of porosity and dry frame bulk modulus for each bin. Consider favoring the data from gassy intervals if these are more stable. Define a continuous function from zero porosity to the maximum encountered for each shale fraction range with a splined or similar fit.

4. Transform the splined fits obtained in "3" above to continuous functions for dry frame Poisson's ratio.

5. Transform the dry frame bulk and shear modulus data points to dry frame Poisson's ratio. Divide the data into bins containing a limited porosity and shale fraction range and compute medians of porosity and dry frame Poisson's ratio for each bin. Define a continuous function from zero porosity to the maximum encountered for each shale fraction range with a splined or similar fit.

6. Choose between the results from step 4 and 5 for estimating dry frame Poisson's ratio from porosity and lithology.

**Estimating elastic properties at modeled saturation**

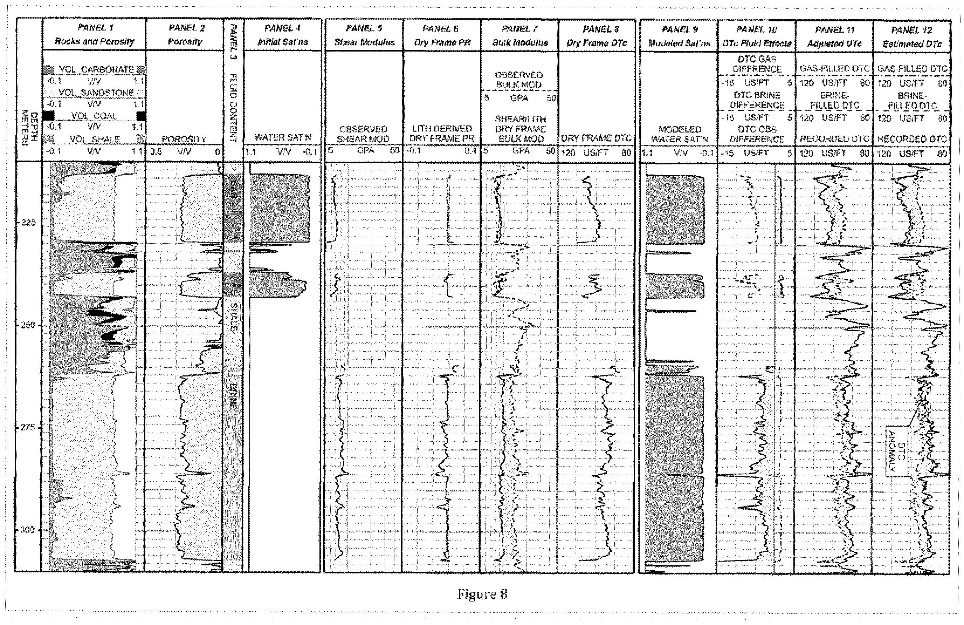

Having derived the transform to estimate dry frame Poisson's ratio, we consider the data from an individual zone of interest. Figure 8 illustrates a typical high porosity sandstone formation with a gas reservoir above a brine filled interval. The goal is to model formation elastic properties for the hypothetical cases of gas reservoir and brine fill throughout the interval. The triplet of density and compressional and shear velocity profiles for the sand are accessed and transformed to other elastic properties using classical linear elastic relations.

The density of a formation at any saturation is defined by linear superposition of the solid and fluid volumes and properties.

$$\rho_{b\ modeled} = (1 - \phi) \times \rho_{solid} + \phi \times \rho_{fluid} \qquad \ldots (6)$$

For the brine filled case, fluid density is that of brine, and for the gas-filled case it is an average of the gas and brine filled densities, weighted by an appropriate gas and water saturation, for example the profile in panel9 of Figure 8.

The premise that shear modulus is unaffected by fluid content enables shear velocity at modeled saturation to be derived from the equation below, where the subscript "observed" denotes the recorded log.

$$DTs_{modeled} = DTs_{observed} \times \sqrt[2]{\rho_{modeled}/\rho_{observed}} \qquad \ldots (7)$$

Equations 6 and 7 are familiar to those well-versed in standard industry practices. Our method differs in treatment of bulk modulus and its implications on estimating compressional velocity under different saturation conditions. The two alternative approaches are illustrated on Figure 8.

Panels 1 to 4 show interpreted lithology, water saturation, fluid fill and porosity. Panel 5 shows shear modulus from recorded density and shear sonic logs. Panel 6 shows Poisson's ratio from the model of Figure 7, panel 4. Panel 7 shows dry frame bulk modulus from the shear modulus and the lithology and porosity based porosity model (solid) compared with bulk modulus from the recorded logs (dashed) to illustrate their similarity in the gas interval where observed and dry frame properties are close, , and the larger fluid effects in the brine filled interval. Using equation 6 with fluid density equal to zero, and populating equation 1 with dry frame properties, delivers the estimated dry frame compressional slowness on panel 8.

The equation 3 variant of the Gassmann is now run three times, to estimate bulk modulus and hence compressional slowness (via equation 1) for the initial saturation profile (panel 4 of Figure 8) the modeled gas reservoir profile (panel 9 of Figure 8) and for brine fill. Panel 10 shows the difference between each of these three slowness results and the dry frame profile. The gas and brine filled cases are plotted with dashed and dot-dash coding, and the observed case solid with shading to zero. Above 250 meters depth the observed and gas cases are effectively synonymous, as are the observed and brine filled cases below 250 meters.

In the first approach, as indicated in operation 12A of method 100, we assume that the compressional sonic log is good quality and the in-situ saturation interpretation of panel 4 is dependable. The brine filled compressional slowness is calculated by adjusting the observed slowness by the difference between the fluid effects on panel 10 for the observed and brine filled cases. Similarly gas filled slowness is from adjusting by the difference between the observed and gas filled cases. The recorded sonic log, together with the results of deriving the brine and gas filled case in this way are shown on panel 11. The final result is the input log adjusted by the modeled fluid effects. In the brine filled interval the observed and brine filled profiles are identical, while in the gas filled interval they are very close but not identical because the interpreted saturation of panel 2 is slightly different from the model of panel 8.

In the second approach, as indicated in operation 12B of method 100, the assumption is that compressional sonic data quality or interpreted water saturation is questionable. The modeled brine filled compressional slowness profile is derived by adjusting the dry frame slowness by the DTc brine difference curve of panel 10. Similar reasoning applies to the gas reservoir case. The result is shown on panel 12 where the two cases are compared with the observed log. The difference between the observed DTc and the modeled brine filled case identifies the prediction error in the estimate of dry frame DTc. In this approach the final results are derived with no reference to the recorded compressional log other than its contribution to the regional database used to build the Poisson's ratio model. The same result would be obtained if the compressional slowness were absent or unusable.

Anomalies in the comparison between the modeled cases and the observed log may be used for quality control. For example, between 264 and 268 meters depth, the observed DTc log converges with the gas filled modeled results. This could indicate a few meters of low saturation gas fill at the top of the lowest sand, missed by the petrophysicist interpreting the log data. This is shown in method 100 as operations 14 and 16.

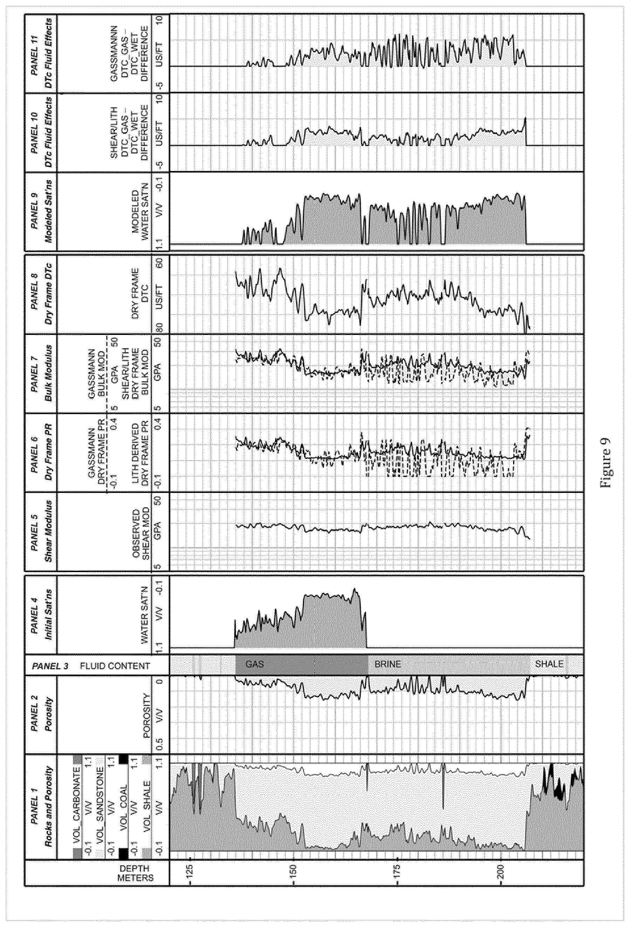

Referring back to Figure 2 highlights the difference between the dry frame bulk modulus and Poisson's ratio from the Gassmann equation and our invention at low porosity. Figure 9 covers the same interval. Panels 6 and 7 compare the lithology and porosity derived dry frame properties with the unstable results derived from Gassmann, particularly in the brine filled interval. Panel 8 shows dry frame compressional slowness from the dry frame lithology-porosity model. Panel 9 shows a gas reservoir saturation model. Transforming the dry frame compressional slowness to brine and gas fill, and taking the gas to brine difference yields the curve of panel 10. It is quite stable and similar values are observed in the gas and brine filled intervals. Panel 11 shows the difference between gas and brine filled compressional slowness derived from the Gassmann-based dry frame bulk modulus on panel 7. It is similar to panel 10 in the gassy interval but very unstable in the brine-filled interval, where large erroneous modeled fluid effects correspond to low Gassmann-derived dry frame Poisson's ratio.

This example illustrates the improvement in stability of modeled results in low porosity formations, particularly in brine filled intervals, when applying the lithology and porosity based Poisson's ratio model.

**Working with low saturation gas**

Occasionally intervals of several tens of meters with low gas saturation are encountered. This is often referred to as "residual gas saturation" because it is believed to occur after the reservoir seal breaches, leaving immobile gas. Over geologic time, diffusion mechanisms transport this gas away leaving a brine-saturated interval.

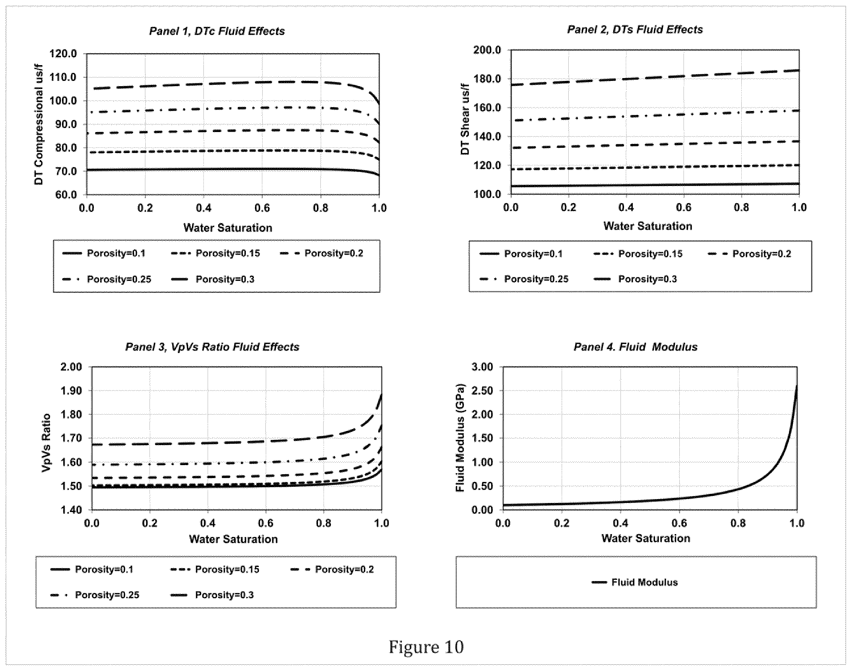

Because low gas saturation cannot be accurately resolved from resistivity-based saturation equations, its presence is generally inferred from the sonic logs by Vp/Vs ratio typical for a gas reservoir. The plots on Figure 10 show the effects of saturation changes on compressional and shear slowness and Vp/Vs ratio for reservoirs with a range of porosity at in-situ pressure of about 5000 psi (approx. 34473.8 kPa). The plots show that the majority of the Vp/Vs ratio change occurs over the water saturation range from about 0.85 to one (gas saturation from 0.15 down to zero) and that the effects diminish with reducing porosity.

A credible estimate of dry frame bulk modulus from the Gassmann equation requires a good knowledge of fluid modulus. This is known with certainty if the formation is unequivocally brine filled, and quite large errors in water saturation below about 0.8 have little influence on results. However, low in-situ gas saturation in the range zero to about 0.15 needs to be accurately resolved in order to define the fluid modulus to populate equation 2.

Rearranging and using a dry frame modulus derived from our model enables the Gassmann equation to be solved for fluid modulus as taught by Murphy (Murphy W., Reischer A., and Hsu K., 1993, "Modulus decomposition of compressional and shear velocities in sand bodies, Geophysics, 58, No 2 February 1993, pp 227 - 239) using equation 8. Note that our dry frame Poisson's ratio model distinguishes our application from Murphy's. The resulting fluid modulus is transformed to saturation using the Reuss average relation plotted on Panel 4 of Figure 10 using equation 9.

$$K_{fluid} = \phi \, K_s \frac{A}{1+\phi A} \ \dots \text{where} \dots \ A = \frac{K_b}{K_s - K_b} - \frac{K_{df}}{K_s - K_{df}} \qquad \dots(8)$$

$$\frac{1}{K_{fluid}} = \frac{Sw}{K_w} - \frac{(1-Sw)}{K_{gas}} \dots \text{leads to} \dots \ Sw = \frac{K_w K_{gas} - K_w K_{fluid}}{K_{fluid} K_{gas} - K_w K_{fluid}} \qquad \dots(9)$$

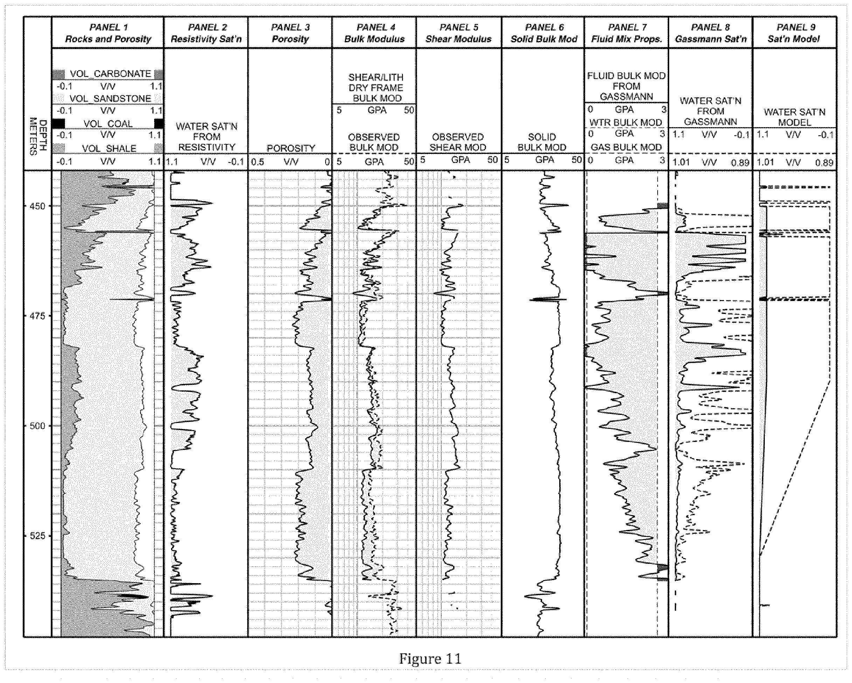

Figure 11 shows how this method implies a tapered low gas saturation profile over an interval interpreted as gassy from the seismic data (not shown), typical of the way low saturation gas can mislead explorationists. Panel 1 shows the analysis for sand and shale, plus occasional coal and carbonate. Water saturation computed from the Indonesia saturation equation, familiar to practitioners, indicates the presence of gas at low and variable saturation, too low for a gas reservoir, and probably residual. The water saturation curve is unstable and appears to be affected by the shalier interval between 480 and 510 meters depth. Panels 3 to 6 show the inputs to the Gassmann equation arrangement of equation 8. "Shear/lith dry frame bulk modulus" is from our invention, and "observed bulk modulus" is from the density and sonic logs. "Solid Bulk Modulus" is a weighted average of the moduli of quartz and shale, the materials that make up the solid part of the formation. Panel 7 shows the computed fluid modulus, smoothed with a five level mean filter to improve appearance, with dashed bounds for gas and water. Using equation 9, fluid modulus is transformed to water saturation, plotted on standard (1.1 to -0.1) and expanded scales (1.01 to 0.89). We infer a tapered profile from 490 to 530 meters depth. This should be used as a reference to propose the simplified saturation model on panel 9 for subsequent elastic property modeling, and to guide an updated petrophysical interpretation superseding the saturation profile of panel 2.

To summarize, solving the Gassmann equation for fluids has identified a tapered low saturation gas that could not realistically be inferred from resistivity based saturation equations.

Although the embodiment of the invention shown in Fig. 12 illustrates the operations being performed in a particular sequence, this is not meant to be limiting. Some operations may be performed in parallel or in a different order. Other operations may also be included at various points in the workflow.

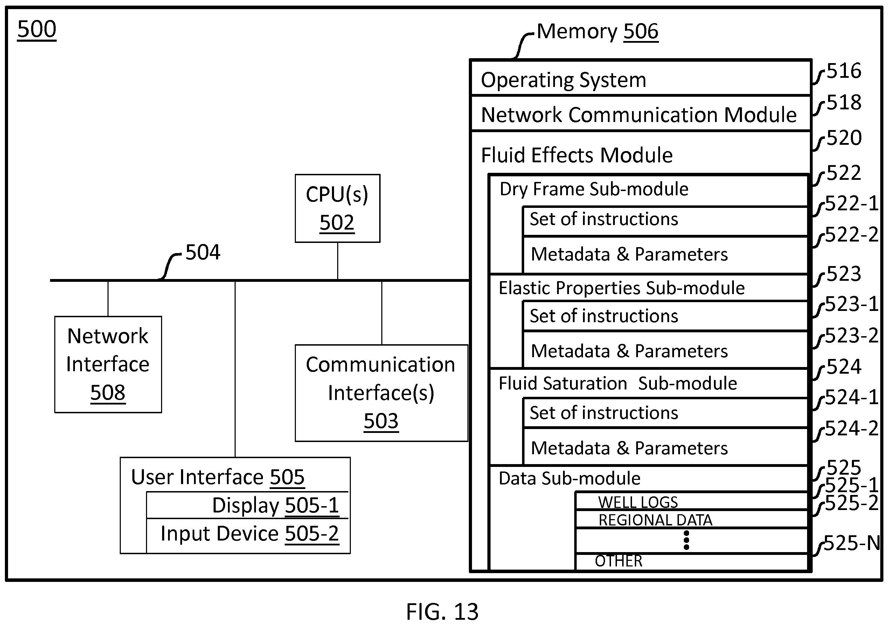

Figure 13 is a block diagram illustrating a fluid substitution system 500, in accordance with some embodiments. While certain specific features are illustrated, those skilled in the art will appreciate from the present disclosure that various other features have not been illustrated for the sake of brevity and so as not to obscure more pertinent aspects of the embodiments disclosed herein.

To that end, the fluid substitution system 500 includes one or more processing units (CPUs) 502, one or more network interfaces 508 and/or other communications interfaces 503, memory 506, and one or more communication buses 504 for interconnecting these and various other components. The fluid substitution system 500 also includes a user interface 505 (e.g., a display 505-1 and an input device 505-2). The communication buses 504 may include circuitry (sometimes called a chipset) that interconnects and controls communications between system components. Memory 506 includes high-speed random access memory, such as DRAM, SRAM, DDR RAM or other random access solid state memory devices; and may include non-volatile memory, such as one or more magnetic disk storage devices, optical disk storage devices, flash memory devices, or other non-volatile solid state storage devices. Memory 506 may optionally include one or more storage devices remotely located from the CPUs 502. Memory 506, including the non-volatile and volatile memory devices within memory 506, comprises a non-transitory computer readable storage medium and may store seismic data, well logs, and/or geologic information.

In some embodiments, memory 506 or the non-transitory computer readable storage medium of memory 506 stores the following programs, modules and data structures, or a subset thereof including an operating system 516, a network communication module 518, and a fluid effects module 520.

The operating system 516 includes procedures for handling various basic system services and for performing hardware dependent tasks.

The network communication module 518 facilitates communication with other devices via the communication network interfaces 508 (wired or wireless) and one or more communication networks, such as the Internet, other wide area networks, local area networks, metropolitan area networks, and so on.

In some embodiments, the fluid effects module 520 executes the operations of method 100. Fluid effects module 520 may include data sub-module 525, which handles the well logs, regional geologic data, and other input and output data 525-1 through 525-N. This data is supplied by data sub-module 525 to other sub-modules.

Dry frame sub-module 522 contains a set of instructions 522-1 and accepts metadata and parameters 522-2 that will enable it to execute operations 10 of method 100. Dry frame sub-module 522 will produce the dry frame bulk modulus and dry frame Poisson's ratio. Elastic properties sub-module 523 contains a set of instructions 523-1 and accepts metadata and parameters 532-2 that will enable it to execute, for example, operations 12A or 12B of method 100. The fluid saturation sub-module 524 contains a set of instructions 524-1 and accepts metadata and parameters 524-2 that will enable it to execute operations 14 and 16 of method 100. Although specific operations have been identified for the sub-modules discussed herein, this is not meant to be limiting. Each sub-module may be configured to execute operations identified as being a part of other sub-modules, and may contain other instructions, metadata, and parameters that allow it to execute other operations of use in fluid substitution and determining fluid saturation in the subsurface reservoir. For example, any of the sub-modules may optionally be able to generate a display that would be sent to and shown on the user interface display 505-1. In addition, any of the well logs or fluid saturation information may be transmitted via the communication interface(s) 503 or the network interface 508 and may be stored in memory 506.

Method 100 is, optionally, governed by instructions that are stored in computer memory or a non-transitory computer readable storage medium (e.g., memory 506 in Figure 3) and are executed by one or more processors (e.g., processors 502) of one or more computer systems. The computer readable storage medium may include a magnetic or optical disk storage device, solid state storage devices such as flash memory, or other non-volatile memory device or devices. The computer readable instructions stored on the computer readable storage medium may include one or more of: source code, assembly language code, object code, or another instruction format that is interpreted by one or more processors. In various embodiments, some operations in each method may be combined and/or the order of some operations may be changed from the order shown in the figures. For ease of explanation, method 100 is described as being performed by a computer system, although in some embodiments, various operations of method 100 are distributed across separate computer systems.

While in the foregoing specification this invention has been described in relation to certain preferred embodiments thereof, and many details have been set forth for purpose of illustration, it will be apparent to those skilled in the art that the invention is disclosed by the appended claims.

**Claims**

1. A computer implemented method for modeling fluid effects in a subsurface reservoir, in order to estimate the economic potential of exploration prospects and to plan well design and placement, the method comprising:

   a. receiving, at a computer processor, a plurality of well logs from a subsurface reservoir and conducting a petrophysical evaluation to determine in-situ porosity, fluid saturation, and lithology;
   b. deriving dry frame properties including bulk and shear modulus and Poisson's ratio from the well logs and evaluation results via a Gassmann equation based method;
   c. aggregating the dry frame properties and plotting the dry frame properties versus porosity and by lithology and dividing the plots into bins covering limited porosity and lithology ranges;
   d. calculating a median porosity-dry frame Poisson's ratio pair for each bin and joining the medians with splined fits to derive a mathematical model to interpolate between medians for any arbitrary porosity-lithology pair to determine interpolated dry frame Poisson's ratios, the interpolation being between adjacent splined fits;
   e. using the combination of a shear modulus from density and shear sonic logs from the plurality of well logs and the interpolated dry frame Poisson's ratio to estimate a modeled dry frame bulk modulus;
   f. using the modeled dry frame bulk modulus to estimate the difference via the Gassmann equation-based method between dry frame compressional and shear velocity and density at a plurality of modeled fluid saturations; and
   g. adjusting recorded compressional and shear velocity and density logs from the plurality of well logs according to the difference between properties at in-situ fluid saturation and the plurality of modeled fluid saturations, and transforming velocity and density to other modeled elastic properties.

2. The method of claim 1 wherein the aggregating gives precedence to data from gas-filled intervals over data from intervals with brine or uncertain fluid.

3. The method of claim 1 wherein the interpolated dry frame Poisson's ratio of step d is derived by interpolation on a plot of dry frame Poisson's ratio versus porosity, split by lithology range.

4. The method of claim 1 wherein dry frame bulk and shear modulus are derived by interpolation on plots versus porosity, split by lithology range, and dry frame Poisson's ratio of step d is calculated from the functions for the two moduli.

5. The method of claim 1 wherein a resulting compressional slowness is derived by adjusting a dry frame compressional slowness derived from dry frame density, shear modulus and bulk modulus.

6. The method of claim 1 wherein the other modeled elastic properties include compressional and shear impedance, VpVs ratio and Poisson's ratio, bulk, shear and Young's modulus and Lamé constants.

7. The method of claim 1 wherein the dry frame bulk modulus is used in a form of the Gassmann equation rearranged to solve for in-situ fluids to enable distinction between brine and low saturation gas fill, and to estimate gas saturation from a calculated fluid modulus.

8. The method of claim 1 wherein the other modeled elastic properties corresponding to the plurality of fluid saturations are invoked to estimate an influence of fluid fill on a measured seismic response of formations of interest to determine a most likely in-situ fluid or whether fluids may be determined from the measured seismic response.

9. A system for modeling fluid effects in a subsurface reservoir, the system comprising:

   a. one or more processors;
   b. a data storage;
   c. memory; and
   d. one or more programs, wherein the one or more programs are stored in the memory and configured to be executed by the one or more processors, the one or more programs including instructions that when executed by the one or more processors cause the device to:

i. derive dry frame properties including bulk and shear modulus and Poisson's ratio from the well logs and evaluation results via a Gassmann equation based method;

ii. aggregate the dry frame properties and plotting the dry frame properties versus porosity and by lithology and dividing the plots into bins covering limited porosity and lithology ranges;

iii. calculate a median porosity-dry frame Poisson's ratio pair for each bin and joining the medians with splined fits to derive a mathematical model to interpolate between medians for any arbitrary porosity-lithology pair to determine interpolated dry frame Poisson's ratios, the interpolation being between adjacent splined fits;

iv. use the combination of a shear modulus from density and shear sonic logs from the plurality of well logs and the interpolated dry frame Poisson's ratio to estimate a modeled dry frame bulk modulus;

v. use the modeled dry frame bulk modulus to estimate the difference via the Gassmann equation-based method between dry frame compressional and shear velocity and density at a plurality of modeled fluid saturations; and

vi. adjust recorded compressional and shear velocity and density logs from the plurality of well logs according to the difference between properties at in-situ fluid saturation and the plurality of modeled fluid saturations, and transform velocity and density to other elastic properties; and

e. a user interface.

10. A computer program comprising instructions which, when executed on a computer, causes the computer to implement a method for modeling fluid effects in a subsurface reservoir, the method comprising:

a. deriving dry frame properties including bulk and shear modulus and Poisson's ratio from well logs and evaluation results via a Gassmann equation based method;

b. aggregating the dry frame properties and plotting the dry frame properties versus porosity and by lithology and dividing the plots into bins covering limited porosity and lithology ranges;

c. calculating a median porosity-dry frame Poisson's ratio pair for each bin and joining the medians with splined fits to derive a mathematical model to interpolate between medians for any arbitrary porosity-lithology pair to determine interpolated dry frame Poisson's ratios, the interpolation being between adjacent splined fits;

d. using the combination of a shear modulus from density and shear sonic logs from the plurality of well logs and the interpolated dry frame Poisson's ratio to estimate a modeled dry frame bulk modulus;

e. using the modeled dry frame bulk modulus to estimate the difference via the Gassmann equation-based method between dry frame compressional and shear velocity and density at a plurality of modeled fluid saturations; and

f. adjusting recorded compressional and shear velocity and density logs from the plurality of well logs according to the difference between properties at in-situ fluid saturation and the plurality of modeled fluid saturations, and transforming velocity and density to other elastic properties.

11. A computer readable medium having the computer program of claim 10 stored thereon.

**Patentansprüche**

1. Ein rechnerimplementiertes Verfahren zum Modellieren von Fluideffekten in einem unterirdischen Reservoir, um das wirtschaftliche Potenzial von Förderaussichten abzuschätzen und Bohrlochdesign und -platzierung zu planen, das Verfahren umfassend:

a. Empfangen, auf einem Rechnerprozessor, einer Mehrzahl Bohrlochprotokolle aus einem unterirdischen Reservoir und Durchführen einer petrophysikalischen Bewertung, um die in-situ-Porosität, die Fluidsättigung und die Lithologie zu bestimmen;

b. Ableiten von Trockenrahmeneigenschaften, umfassend Kompressions- und Schermodul und Poisson'sches Verhältnis von den Bohrlochprotokollen und Evaluationsergebnissen über ein auf einer Gassmann-Gleichung basierenden Verfahren;

c. Aggregieren der Trockenrahmeneigenschaften und Auftragen der Trockenrahmeneigenschaften gegen Porosität und durch Lithologie und Aufteilen der Graphen in Klassen, die begrenzte Porositäts- und Lithologiebereiche abdecken;

d. Berechnen eines mittleren Poisson'schen Verhältnispaars des Porositäts-Trockenrahmens für jede Klasse und Verbinden der Mediane mit Splined-Fits, um ein mathematisches Modell zur Interpolation zwischen Medianen für ein beliebiges Porositäts-Lithologie-Paars abzuleiten, um die interpolierten Poisson'schen Verhältnisse des Trockenrahmens zu bestimmen, wobei die Interpolation zwischen benachbarten Splined-Fits erfolgt;

e. Verwenden der Kombination eines Schermoduls aus Dichte und Scherschallprotokollen aus der Mehrzahl Bohrlochprotokolle und des interpolierten Poisson'schen Verhältnisses des Trockenrahmens, um ein modelliertes Trockenrahmenkompressionsmodul abzuschätzen;

f. Verwenden des modellierten Trockenrahmenkompressionsmoduls, um die Differenz über das auf einer Gassmann-Gleichung basierende Verfahren zwischen Trockenrahmenkompressions- und Schergeschwindigkeit und Dichte bei einer Mehrzahl modellierter Fluidsättigungen abzuschätzen; und

g. Anpassen von aufgezeichneten Kompressions- und Schergeschwindigkeitsprotokollen und Dichteprotokollen aus der Mehrzahl Bohrlochprotokolle gemäß dem Unterschied zwischen Eigenschaften bei in-situ-Fluidsättigung und der Mehrzahl modellierter Fluidsättigungen, und Transformieren von Geschwindigkeit und Dichte in andere modellierte elastische Eigenschaften.

2. Verfahren gemäß Anspruch 1, worin das Aggregieren Daten aus gasgefüllten Intervallen den Vorrang gegenüber Daten aus Intervallen mit Salzlauge oder ungewissem Fluid gibt.

3. Verfahren gemäß Anspruch 1, worin das interpolierte Poisson'sche Verhältnis des Trockenrahmens aus Schritt d durch Interpolation auf einem Graph, auf dem das Poisson'sche Verhältnis des Trockenrahmens gegen Porosität aufgetragen ist, abgeleitet wird, aufgeteilt nach Lithologiebereich.

4. Verfahren gemäß Anspruch 1, worin das Trockenrahmenkompressions- und Schermodul abgeleitet wird durch Interpolation auf Graphen gegen Porosität, aufgeteilt durch den Lithologiebereich, und das Poisson'sche Verhältnis des Trockenrahmens aus Schritt d aus den Funktionen für die zwei Moduli berechnet wird.

5. Verfahren gemäß Anspruch 1, worin eine resultierende Kompressionsverlangsamung abgeleitet wird durch das Einstellen einer Trockenrahmenkompressionsverlangsamung, abgeleitet von der Trockerahmendichte, dem Schermodul und dem Kompressionsmodul.

6. Verfahren gemäß Anspruch 1, worin die weiteren modellierten elastischen Eigenschaften Kompressions- und Scherimpedanz, VpVs-Verhältnis und Poisson'sche Verhältnis, Kompressions-, Scher- und Young's Modul und Lame Konstanten umfassen.

7. Verfahren gemäß Anspruch 1, worin Trockenrahmenkompressionsmodul in einer Form der Gassmann-Gleichung verwendet wird, neu angeordnet, um für in-situ Fluide zu lösen, um die Unterscheidung zwischen Salzlauge und einer Gasfüllung mit niedriger Sättigung zu ermöglichen, und Gassättigung von einem berechneten Fluidmodul abzuschätzen.

8. Verfahren gemäß Anspruch 1, worin die weiteren modellierten elastischen Eigenschaften, entsprechend der Mehrzahl Fluidsättigungen, aufgerufen werden, um einen Einfluss der Fluidfüllung auf eine gemessene seismische Reaktion von Formationen von Interesse abzuschätzen, um ein höchstwahrscheinliches in-situ Fluid zu bestimmen oder ob Fluide aus der gemessenen seismischen Reaktion bestimmt werden können.

9. System zur Modellierung von Fluideffekten in einem unterirdischen Reservoir, das System umfassend:

a. ein oder mehrere Prozessoren;
b. einen Datenspeicher;
c. Speicher; und
d. ein oder mehrere Programme, worin die einen oder mehreren Programme im Speicher abgelegt und konfiguriert sind, von dem einen oder den mehreren Prozessoren ausgeführt zu werden, das eine oder die mehreren Programme umfassend Anweisungen, die, wenn von dem einen oder den mehreren Prozessoren ausgeführt, das Gerät dazu veranlassen:

i. Trockenrahmeneigenschaften abzuleiten, umfassend Kompressionsund Schermodul und Poisson'sches Verhältnis von den Bohrlochprotokollen und Evaluationsergebnissen über ein auf einer Gassmann-Gleichung basierenden Verfahren;

ii. die Trockenrahmeneigenschaften zu aggregieren und die Trockenrahmeneigenschaften gegen Porosität und durch Lithologie aufzutragen und Aufteilen der Graphen in Klassen, begrenzte Porositäts- und Lithologiebereiche abdeckend;

iii. ein mittleres Poisson'sche Verhältnispaar des Porositäts-Trockenrahmens für jede Klasse zu berechnen und die Mediane mit Splined-Fits zu verbinden, um ein mathematisches Modell zur Interpolation zwischen Medianen für jedes beliebige Porositäts-Lithologie-Paar abzuleiten, um interpolierte Poisson'sche Verhältnisse des Trockenrahmens zu bestimmen, wobei die Interpolation zwischen benachbarten Splined-Fits erfolgt;

iv. die Kombination eines Schermoduls aus Dichte und Scherschallprotokollen aus der Mehrzahl Borhlochprotokolle und des interpolierten Poisson'schen Verhältnisses des Trockenrahmens zu verwenden, um ein modelliertes Trockenrahmenkompressionsmodul abzuschätzen;

v. das modellierte Trockenrahmenkompressionsmodul zu verwenden, um die Differenz über das auf einer Gassmann-Gleichung basierende Verfahren zwischen Trockenrahmenkompressions- und Schergeschwindigkeit und Dichte bei einer Mehrzahl modellierter Fluidsättigungen abzuschätzen; und

vi. aufgezeichnete Kompressions- und Schergeschwindigkeitsprotokolle und Dichteprotokolle aus der Mehrzahl Bohrlochprotokolle gemäß dem Unterschied zwischen Eigenschaften bei in-situ-Fluidsättigung und der Mehrzahl modellierter Fluidsättigungen anzupassen und die Geschwindigkeit und Dichte in andere modellierte elastische Eigenschaften umzuwandeln; und

e. eine Benutzeroberfläche.

10. Rechnerprogramm, umfassend Anweisungen, die, wenn auf einem Rechner ausgeführt, den Rechner dazu veranlassen ein Verfahren zum Modellieren von Fluideffekten in einem unterirdischen Reservoir zu implementieren, das Verfahren umfassend:

a. Ableiten von Trockenrahmeneigenschaften, umfassend Kompressions- und Schermodul und Poisson'sche Verhältnis von Bohrlochprotokollen und Evaluationsergebnisse über ein auf einer Gassmann-Gleichung basierenden Verfahren;

b. Aggregieren der Trockenrahmeneigenschaften und Auftragen der Trockenrahmeneigenschaften gegen Porosität und durch Lithologie und Aufteilen der Graphen in Klassen, begrenzte Porositäts- und Lithologiebereiche abdeckend;

c. Berechnen des mittleren Poisson'schen Verhältnispaars des Porositäts-Trockenrahmens für jede Klasse und Verbinden der Mediane mit Splined-Fits, um ein mathematisches Modell zur Interpolation zwischen Medianen für jedes beliebige Porositäts-Lithologie-Paar abzuleiten, um die interpolierten Poisson'schen Verhältnisse des Trockenrahmens zu bestimmen, wobei die Interpolation zwischen benachbarten Splined-Fits erfolgt;

d. Verwenden der Kombination eines Schermoduls aus Dichte und Scherschallprotokollen aus der Mehrzahl Borhlochprotokolle und des interpolierten Poisson'schen Verhältnisses des Trockenrahmens, um ein modelliertes Trockenrahmenkompressionsmodul abzuschätzen;

e. Verwenden des modellierten Trockenrahmenkompressionsmoduls, um die Differenz über das auf einer Gassmann-Gleichung basierende Verfahren zwischen Trockenrahmenkompressions- und Schergeschwindigkeit und Dichte bei einer Mehrzahl modellierter Fluidsättigungen abzuschätzen; und

f. Anpassen von aufgezeichneten Kompressions- und Schergeschwindigkeitsprotokollen und Dichteprotokollen aus der Mehrzahl Bohrlochprotokolle gemäß dem Unterschied zwischen Eigenschaften bei in-situ-Fluidsättigung und der Mehrzahl modellierter Fluidsättigungen und Transformieren der Geschwindigkeit und Dichte in andere modellierte elastische Eigenschaften.

11. Rechnerlesbares Medium mit einem darauf gespeicherten Rechnerprogramm gemäß Anspruch 10.

**Revendications**

1. Un procédé mis en œuvre par ordinateur pour modéliser des effets de fluide dans un réservoir souterrain, afin d'estimer le potentiel économique de perspectives d'exploration et de planifier la conception et le placement des puits, le procédé comprenant:

a. recevoir, sur un processeur informatique, une pluralité de rapports de forage provenant d'un réservoir souterrain et mener une évaluation pétrophysique afin de déterminer la porosité in-situ, la saturation de fluide et la lithologie;

b. dériver des propriétés du cadre sec comprenant le module de compressibilité et de cisaillement et le rapport de Poisson à partir des rapports de forage et des résultats d'évaluation par un procédé fondé sur l'équation de Gassmann;

c. agrégation des propriétés du cadre sec et représenter le traçage de propriétés du cadre sec en fonction de la porosité et de la lithologie et diviser les réprésentations graphiques en classes couvrant les gammes de porosité et lithologie limitées;

d. calculer une paire médiane de couple porosité-rapport de Poisson du cadre sec pour chaque bac et joindre les médianes avec des ajustements cannelés pour dériver un modèle mathématique pour interpoler entre les médianes pour quelconque paire porosité-lithologie arbitraire pour déterminer des rapports de Poisson du cadre sec interpolés, l'interpolation étant entre des ajustement cannelés adjacents;

e. utiliser la combinaison du module de cisaillement de la densité et des diagraphies soniques de cisaillement de la pluralité de rapports de forage et du rapport de Poisson du cadre sec interpolé pour estimer un module de compressibilité modélisé du cadre sec;

f. utiliser le module de compressibilité modélisé du cadre sec pour estimer la différence par le procédé fondé sur l'équation de Gassmann entre la vitesse de compression et de cisaillement du cadre sec et la densité à une pluralité de saturations de fluide modélisées; et

g. ajuster la vitesse de compression et de cisaillement et des diagraphies de la densité enregistrées de la pluralité de rapports de forage selon la différence entre les propriétés à la saturation de fluide in-situ et la pluralité de saturations de fluide modélisées et transformer la vitesse et la densité en d'autres propriétés élastiques modélisées.

2. Le procédé selon la revendication 1, dans lequel l'agrégation donne priorité aux données d'intervalles à gaz par rapport aux données d'intervalles avec la saumure ou un fluide incertain.

3. Le procédé selon la revendication 1, dans lequel le rapport de Poisson interpolé du cadre sec de l'étape d est dérivé par interpolation sur un graphique réprésentant la relation du rapport de Poisson du cadre sec en fonction de la porosité, divisée par la gamme de lithologie.

4. Le procédé selon la revendication 1, dans lequel les modules de compressibilité et de cisaillement du cadre sec sont dérivés par interpolation sur les graphiques en fonction de la porosité, divisée par la gamme de lithologie, et le rapport de Poisson du cadre sec de l'étape d est calculé à partir des fonctions pour les deux modules.

5. Le procédé selon la revendication 1, dans lequel une lenteur de compression résultante est dérivée en ajustant une lenteur de compression du cadre sec dérivée de la densité du cadre sec, du module de cisaillement et du module de compressibilité.

6. Le procédé selon la revendication 1, dans lequel les autres propriétés élastiques modélisées comprennent l'impédance en compression et en cisaillement, le rapport VpVs et le rapport de Poisson, le module de compressibilité, le module de cisaillement et le module de Young et les constantes de Lamé.

7. Le procédé selon la revendication 1, dans lequel le module de compressibilité du cadre sec est utilisé dans une forme de l'équation de Gassmann réarrangée à résoudre pour les fluides in-situ pour permettre la distinction entre la saumure et le remplissage en gaz à faible saturation et estimer la saturation en gaz à partir d'un module calculé de fluide.

8. Le procédé selon la revendication 1, dans lequel les autres propriétés élastiques modélisées correspondant à la pluralité de saturations de fluide sont invoquées pour estimer une influence du remplissage fluide sur une réponse sismique mesurée des formations d'intérêt pour déterminer un fluide in-situ le plus probable ou si les fluides peuvent être déterminer à partir de la réponse sismique mesurée.

9. Un système pour modéliser des effets de fluide dans un réservoir souterrain, le système comprenant:

a. un ou plusieurs processeurs;
b. un stockage de données;
c. une mémoire; et
d. un ou plusieurs logiciels, dans lequel l'un ou les plusieurs logiciels sont stockés dans la mémoire et configurés pour être exécutés par l'un ou les plusieurs processeurs, l'un ou les logiciels comprenant des instructions qui, lorsqu'elles sont exécutées par l'un ou les plusieurs processeurs, amènent l'appareil à:

i. dériver des propriétés du cadre sec comprenant le module de compressibilité et de cisaillement et le rapport de Poisson à partir des rapports de forage et des résultats d'évaluation par un procédé fondé sur l'équation de Gassmann;

ii. agrégation des propriétés du cadre sec et représenter le traçage de propriétés du cadre sec en fonction de la porosité et de la lithologie et diviser les réprésentations graphiques en classes couvrant les gammes de porosité et lithologie limitées;

iii. calculer une paire médiane de couple porosité-rapport de Poisson du cadre sec pour chaque bac et joindre les médianes avec des ajustements cannelés pour dériver un modèle mathématique pour interpoler entre les médianes pour quelconque paire porosité-lithologie arbitraire pour déterminer des rapports de Poisson du cadre sec interpolés, l'interpolation étant entre des ajustement cannelés adjacents;

iv. utiliser la combinaison d'un module de cisaillement à partir de la densité et des diagraphies soniques de cisaillement de la pluralité de rapports de forage et du rapport de Poisson du cadre sec interpolé pour estimer un module de compressibilité modélisé du cadre sec;

v. utiliser le module de compressibilité modélisé du cadre sec pour estimer la différence par le procédé fondé sur l'équation de Gassmann entre la vitesse de compression et de cisaillement du cadre sec et la densité à une pluralité de saturations de fluide modélisées; et

vi. ajuster la vitesse de compression et de cisaillement et des diagraphies de la densité enregistrées de la pluralité de rapports de forage selon la différence entre les propriétés à la saturation de fluide in-situ et la pluralité de saturations de fluide modélisées et transformer la vitesse et la densité en d'autres propriétés élastiques; et

e. une interface utilisateur.

**10.** Un logiciel informatique comprenant des instructions, qui, lorsqu'elles sont exécutées par un ordinateur, amènent l'ordinateur de mettre en oeuvre un procédé pour modéliser des effets de fluide dans un réservoir souterrain, le procédé comprenant:

a. dériver des propriétés du cadre sec comprenant le module de compressibilité et de cisaillement et le rapport de Poisson à partir des rapports de forage et des résultats d'évaluation par un procédé fondé sur l'équation de Gassmann;

b. agrégation des propriétés du cadre sec et représenter le traçage de propriétés du cadre sec en fonction de la porosité et de la lithologie et diviser les réprésentations graphiques en classes couvrant les gammes de porosité et lithologie limitées;

c. calculer une paire médiane de couple porosité-rapport de Poisson du cadre sec pour chaque classe et joindre les médianes avec des ajustements cannelés pour dériver un modèle mathématique pour interpoler entre les médianes pour quelconque paire porosité-lithologie arbitraire pour déterminer des rapports de Poisson du cadre sec interpolés, l'interpolation étant entre des ajustement cannelés adjacents;

d. utiliser la combinaison du module de cisaillement à partir de la densité et des diagraphies soniques de cisaillement de la pluralité de rapports de forage et du rapport de Poisson du cadre sec interpolé pour estimer un module de compressibilité modélisé du cadre sec;

e. utiliser le module de compressibilité modélisé du cadre sec pour estimer la différence par le procédé fondé sur l'équation de Gassmann entre la vitesse de compression et de cisaillement du cadre sec et la densité à une pluralité de saturations de fluide modélisées;

f. ajuster la vitesse de compression et de cisaillement et des diagraphies de la densité enregistrées de la pluralité de rapports de forage selon la différence entre les propriétés à la saturation de fluide in-situ et la pluralité de saturations de fluide modélisées et transformer la vitesse et la densité en d'autres propriétés élastiques.

**11.** Un support lisible par ordinateur sur lequel le logiciel informatique selon la revendication 10 est stocké.

Poisson's Ratio vs. Shear Modulus

Figure 1B

Bulk Modulus vs. Shear Modulus

Figure 1A

Figure 2

Figure 3

Figure 4

Figure 5

Figure 6

Figure 7

Figure 8

Figure 9

Figure 10

Figure 11

Figure 12

FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- The Rock Physics Handbook Section 5.4. 245
- **MAVKO G ; MUKERJI T ; DVORKIN J.** The Rock Physics Handbook. Cambridge University Press, 2010
- **XU, S ; WHITE RE.** A new velocity model for clay-sand mixtures. *Geophysical Prospecting,* 1995, vol. 43, 91-118
- **SMITH T.** Practical Seismic Petrophysics: The effective use of log data for seismic analysis. *2011, The Leading Edge,* October 2011, 1128-1141

- **SAUL M ; LUMLEY D ; SHRAGGE J.** Modeling the pressure sensitivity of uncemented sediments using a modified grain contact theory: Incorporating grain relaxation and porosity effects. *Geophysics,* 2013, vol. 78 (5), 327-338
- **GREENBERG, M.L. ; CASTAGNA, J.P.** Shear wave velocity estimation in porous rocks: Theoretical formulation, preliminary verification and applications. *Geophysical Prospecting,* 1992, vol. 40, 195-209
- **MURPHY W. ; REISCHER A. ; HSU K.** Modulus decomposition of compressional and shear velocities in sand bodies. *Geophysics,* February 1993, vol. 58 (2), 227-239